# EUROPEAN PATENT SPECIFICATION

(11) **EP 2 863 719 B1**
(45) Date of publication and mention of the grant of the patent: **23.09.2020**
(21) Application number: 14188982.4
(22) Date of filing: 15.10.2014
(51) Int. Cl.: H05K 1/09, H05K 3/12, H05K 1/02, H05B 3/26

(54) **Heating elements for aircraft heated floor panels**
Heizelemente für beheizte Bodenplatten von Flugzeugen
Éléments de chauffage des panneaux de plancher chauffé d'aéronef

(30) Priority: 15.10.2013 US 201361891276 P; 15.10.2013 US 201361891292 P; 12.02.2014 US 201414179281
(43) Date of publication of application: 22.04.2015
(73) Proprietor: Goodrich Corporation, Charlotte, NC 28217-4578 (US)
(72) Inventor: Hu, Jin, Hudson, Ohio 44236 (US); Hamm, Richard R., Brooklin, Maine 04616 (US); Roach, Kevin E, Stow, Ohio 44224 (US)
(74) Representative: Dehns

(56) References cited:
- EP-A1- 0 065 419
- WO-A2-03/001849
- US-A1- 2010 065 686
- PIQUE A ET AL: "Embedding electronic circuits by laser direct-write", MICROELECTRONIC ENGINEERING, ELSEVIER PUBLISHERS BV., AMSTERDAM, NL, vol. 83, no. 11-12, 1 November 2006 (2006-11-01), pages 2527-2533, XP024954828, ISSN: 0167-9317, DOI: 10.1016/J.MEE.2006.06.004 [retrieved on 2006-11-01]

## Description

### BACKGROUND OF THE INVENTION

### 1. Field of the Invention

The present disclosure relates to heating circuits, and more particularly to resin-based conductive ink circuits.

### 2. Description of Related Art

Traditionally, resistive heating elements of heated floor panels are chemically etched alloy elements. The etch process is fairly involved and requires multiple steps. While satisfactory for its intended purpose the traditional etch process can be time consuming, cause manufacturing difficulties and delay due to over- or under-etch (making resistance too high or too low) or defects due to the photo-print process, and can lead to failure due to mechanical fatigue in the field.

Such conventional methods and systems have generally been considered satisfactory for their intended purpose. However, there is still a need in the art for methods and systems that allow for improved ease of manufacture and mechanical strength while still maintaining the required resistivity. The present disclosure provides a solution for these problems.

WO 03/001849 discloses a thick film heater wherein the thick film heating element is applied to a target object to be heated.

### SUMMARY OF THE INVENTION

A method of forming a heating element for an aircraft heated floor panel includes depositing a conductive ink of silver particles in an epoxy resin on a dielectric film to create a conductive circuit, and temperature heat curing the conductive circuit to achieve a resistivity of the heating element less than 1.68 x 10⁻⁶ ohm·meter. The silver loading is between 65% - 95% weight/weight of dry ink. The conductive ink is configured such that a 0.002 inch (50.8 microns) to .004 inch (101.6 microns) thick post-cure layer of the conductive ink can achieve the resistivity of the heating element and be bent around a 1/4 inch (0.635 cm) diameter cylinder rod without experiencing electric resistance degradation.

It is contemplated that the step of heat curing can include curing at a temperature between 155° C - 200° C, and/or at a temperature between a glass transition temperature of the conductive ink and a maximum thermal stability temperature of the conductive ink. The glass transition temperature can be lower than the maximum thermal stability temperature and the maximum thermal stability temperature can be greater than 155° C. For example, the maximum thermal stability temperature of the conductive ink can exceed 200° C. In certain applications, the silver loading can be between 75% - 89% weight/weight of dry ink. The step of depositing can include screen printing the conductive ink onto the dielectric film, and/or can include depositing the conductive ink in a patterned layer. In addition, the step of curing can include post-curing at a temperature of at least 200° C, and/or can include heat curing at predetermined time intervals. The method can also include applying the conductive circuit to at least one panel skin of an aircraft floor panel. It is also contemplated that the cylinder rod could have a 1/8 inch (0.3175 cm) diameter, or lower.

In accordance with certain embodiments, at least one floor panel of an aircraft includes a heating element with a conductive circuit positioned within the floor panel. The conductive circuit includes a conductive ink of silver particles in an epoxy resin on a dielectric film.

It is also contemplated that the conductive ink can be disposed onto the dielectric film in patterned layers. Further, the silver loading, curing and post-curing temperatures, and resistivity of the heating element are much as described above.

These and other features of the systems and methods of the subject disclosure will become more readily apparent to those skilled in the art from the following detailed description of the preferred embodiments taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in greater detail herein below by way of example only and with reference to certain figures, wherein:
Fig. 1 is a top plan view of an exemplary embodiment of an aircraft heated floor panel constructed in accordance with the present disclosure, schematically showing the conductive circuit with conductive ink of silver particles in an epoxy resin on a dielectric film; and
Fig. 2 is a top plan view of an exemplary embodiment view of an aircraft heated floor panel constructed in accordance with the present disclosure, schematically showing the conductive circuit with conductive ink of silver particles in an epoxy resin disposed onto a dielectric film in a patterned layer.

### DETAILED DESCRIPTION OF THE PREFERRED EMBODIMENTS

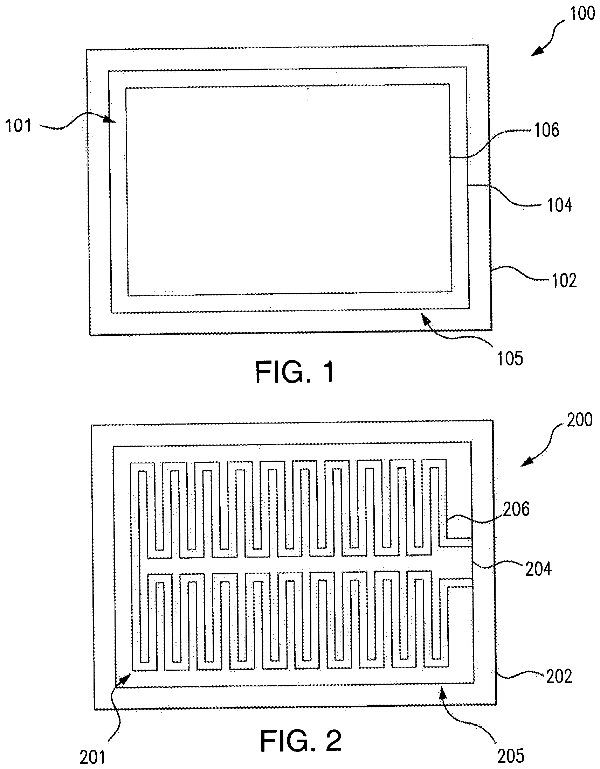

Reference will now be made to the drawings wherein like reference numerals identify similar structural features or aspects of the subject disclosure. For purposes of explanation and illustration, and not limitation, an exemplary embodiment of an aircraft heated floor panel in accordance with the disclosure is shown in Fig. 1 and is designated generally by reference character 100. Other embodiments of the aircraft heated floor panel in accordance with the disclosure, or aspects thereof, are provided in Fig. 2, as will be described. The systems and methods described herein can be used heating elements of heated floor panels, and/or other aircraft electrothermal heaters including ice protection systems for high power density, high temperature applications.

Screen printed resin-based conductive ink heating elements tend to be easier to manufacture than traditional chemically etched alloy resistive heating elements. Screen printed resin-based conductive inks, however, can require low resistivity of the heating elements, for example 1.68 x 10⁻⁶ ohm·meter or lower. High metal particle loading of the conductive ink can achieve such low resistivity, but there may be a trade-off of reduced mechanical strength.

As show in Fig. 1, an aircraft heated floor panel 100 includes at least one floor panel 102 of an aircraft and a heating element 105 including a conductive circuit 101 positioned within floor panel 102. Conductive circuit 101 includes a conductive ink 106 of silver nano-particles in an epoxy resin on a dielectric film 104. While shown schematically as a rectangle, it will be appreciated that conductive ink 106 can be disposed onto dielectric film 104 in a variety of patterned layers, e.g. by screen printing. Multiple screen printed thin layers of conductive ink 106 allow for laterally aligned platelet or needle shape silver particles which tend to cause low electric resistivity.

The silver loading can be between 65% - 95% weight/weight of dry ink. For example, in certain applications, the silver loading can be between 75% - 89% weight/weight of dry ink. The conductive circuit 101 can be post-cured at a temperature of 200° C. It may be post-cured at a temperature between a glass transition temperature of the conductive ink and a maximum thermal stability temperature of the conductive ink. The resistivity of the heating element 105 may be less than 1.68 x 10⁻⁶ ohm·meter. The maximum thermal stability temperature of the conductive ink can vary as is suitable for a given conductive ink used. In addition, the glass transition temperature can be lower than the maximum thermal stability temperature and the maximum thermal stability temperature can be greater than 155° C. For example, the maximum thermal stability temperature of the conductive ink can exceed 200° C.

As show in Fig. 2, an aircraft heated floor panel 200 includes at least one floor panel 202 of an aircraft and a heating element 205 including a conductive circuit 201 positioned within floor panel 202. Conductive circuit 201 includes a conductive ink 206 of silver particles in an epoxy resin on a dielectric film 204, substantially similar to aircraft heated floor panel 100 as described above. In Fig. 2, however, conductive ink 206 is disposed onto dielectric film 204 in a patterned layer. The high silver loading of the conductive ink, post-curing temperatures, and resistivity of heating element, with respect to aircraft heated floor panel 200, can all be similar to those described above with respect to aircraft heated floor panel 100.

With reference now to Figs. 1 and 2, a method of forming a heating element, e.g. heating element 105 or 205, for an aircraft heated floor panel, e.g. aircraft heated floor panel 100 or 200 includes depositing a conductive ink, e.g. conductive ink 106 or 206, of silver particles in an epoxy resin on a dielectric film, e.g. dielectric film 104 or 204, to create a conductive circuit, e.g. conductive circuit 101 or 201. The conductive circuit is heat cured at a high temperature to achieve a resistivity of the heating element less than 1.68 x 10⁻⁶ ohm·meter. The method of forming the heating element for the aircraft heated floor panel includes applying the conductive circuit to at least one panel skin of an aircraft floor panel, e.g. aircraft floor panel 101 or 202.

It will be appreciated that depositing the conductive ink includes depositing a patterned layer of the conductive ink, e.g., as shown in Fig. 2. The step of heat curing can include curing at a temperature between 155° C - 200° C, and/or between a glass transition temperature of the conductive ink and a maximum thermal stability temperature of the conductive ink. In other words, for example, the step of heat curing can include curing at a temperature greater than 200° C depending on the thermal stability temperature of the conductive ink used.

The silver loading can be between 65% - 95% weight/weight of dry ink, and/or the step of depositing can include screen printing the conductive ink onto the dielectric film. For example, in certain applications, the silver loading can be between 75% - 89% weight/weight of dry ink. In addition, the step of curing can include post-curing at a temperature of at least 200° C, and/or can include heat curing at predetermined time intervals.

It may be appreciated that with the high silver loading, high temperature post curing, and the appropriate cure time intervals, as described above, various low resistivity numbers between those of Inconel® 600 ½ hard (1.680 x 10⁻⁶ ohm·meter), available from Special Metals Corporation, Huntington, West Virginia, and those of stainless steel, e.g. SS 302-2B (7.198 × 10^{- 7}ohm·meter), or even resistivity numbers as low as those of Monel® 401 (5.07 × 10⁻⁷ ohm·meter), also available from Special Metals Corporation, can be achieved for conductive ink, e.g. conductive ink 106.

It will be appreciated that conductive ink, e.g. conductive ink 106, can achieve the resistivity described above without sacrificing mechanical strength and durability. For example, a 0.002 inch (50.8 microns) to .004 inch (101.6 microns) thick post-cure layer of conductive ink 106 is configured to be bent around a 1/4 inch (0.635 cm) diameter cylinder rod without experiencing electric resistance degradation. It is also contemplated that cylinder rod can be a 1/8 inch (0.3175 cm) in diameter, or lower.

The methods and systems of the present disclosure, as described above and shown in the drawings, provide for an aircraft heated floor panel with superior properties including reduced rework, scrap and defects, reduced labor and chemical disposal costs and better fatigue resistance than traditional heated floor panels. While the apparatus and methods of the subject disclosure have been shown and described with reference to preferred embodiments, those skilled in the art will readily appreciate that changes and/or modifications may be made thereto without departing from the scope of the subject disclosure as defined by the claims.

## Claims

1. A method of forming a heating element (105,205) for an aircraft heated floor panel, the method comprising:
depositing a conductive ink (106; 206) of silver particles in an epoxy resin to create a conductive circuit (101; 201); and
heat curing the conductive circuit to achieve a resistivity of the heating element less than 1.68 x 10⁻⁶ ohm·meter;
**characterised in that** the conductive ink is deposited on a dielectric film; a 0.001 inch (50.8 microns) to .004 inch (101.6 microns) thick post-cure layer of the conductive ink is configured to achieve the resistivity of the heating element and be bent around a 1/4 inch (0.635 cm) diameter cylinder rod without experiencing electrical resistance degradation; and the silver loading is between 65% - 95% weight/weight of dry ink.

2. A method as recited in claims 1 or 2, wherein the step of heat curing includes curing at a temperature between 155° C - 200° C.

3. A method as recited in any preceding claim, wherein the step of heat curing includes curing at a temperature between a glass transition temperature of the conductive ink and a maximum thermal stability temperature of the conductive ink, wherein the glass transition temperature is lower than the maximum thermal stability temperature and the maximum thermal stability temperature is greater than 155° C.

4. A method as recited in any preceding claim, wherein the step of depositing includes screen printing the conductive ink onto the dielectric film.

5. A method as recited in any preceding claim, wherein the step of depositing includes depositing a patterned layer of the conductive ink.

6. A method as recited in any preceding claim, further including applying the conductive circuit to at least one panel skin of an aircraft floor panel.

7. An aircraft heated floor panel (100; 200) comprising:
at least one floor panel (102; 202) of an aircraft includes a heating element (105; 205) with a conductive circuit (101; 201) positioned within the floor panel, where the resistivity of the heating element is less than 1.68 x 10⁻⁶ ohm·meter; wherein the conductive circuit includes a cured conductive ink (106; 206); **characterised in that**
the ink is an ink of silver particles in an epoxy resin deposited on a dielectric film (104; 204), wherein a 0.001 inch (50.8 microns) to .004 inch (101.6 microns) thick post-cure layer of the conductive ink is configured to achieve the resistivity of the heating element and be bent around a 1/4 inch (0.635 cm) diameter cylinder rod without experiencing electrical resistance degradation, and wherein the silver loading is between 65% - 95% weight/weight of dry ink.

8. An aircraft heated floor panel as recited in claim 7, wherein the cured conductive ink is disposed onto the dielectric film in a patterned layer.

9. An aircraft heated floor panel as recited in claim 7 or 8, wherein the conductive circuit is post-cured at a temperature between a glass transition temperature of the conductive ink and a maximum thermal stability temperature of the conductive ink, wherein the glass transition temperature is lower than the maximum thermal stability temperature and the maximum thermal stability temperature is greater than 155° C.

## Patentansprüche

1. Verfahren zum Formen eines Heizelements (105, 205) für eine beheizte Bodenplatte eines Flugzeugs, wobei das Verfahren Folgendes umfasst:
Abscheiden einer leitfähigen Tinte (106; 206) aus Silberpartikeln in einem Epoxidharz, um eine leitende Schaltung (101; 201) zu erzeugen; und
Wärmehärten der leitenden Schaltung, um einen spezifischen Widerstand des Heizelements zu erreichen, der kleiner als 1,68 x 10-6 Ohmmeter ist;
**dadurch gekennzeichnet, dass** die leitfähige Tinte auf einem dielektrischen Film abgeschieden wird; eine 0,001 Zoll (50,8 Mikrometer) bis 0,004 Zoll (101,6 Mikrometer) dicke Nachhärtungsschicht der leitfähigen Tinte konfiguriert ist, um den spezifischen Widerstand des Heizelements zu erreichen und um eine Zylinderstange mit einem Durchmesser von 1/4 Zoll (0,635 cm) gebogen zu sein, ohne eine Verschlechterung des elektrischen Widerstands zu erfahren; und die Silberbelastung zwischen 65 Gew.-%-95 Gew.-% trockener Tinte entspricht.

2. Verfahren nach Anspruch 1 oder 2, wobei der Schritt des Wärmehärtens das Härten bei einer Temperatur zwischen 155 °C-200 °C einschließt.

3. Verfahren nach einem der vorhergehenden Ansprüche, wobei der Schritt des Wärmehärtens das Härten bei einer Temperatur zwischen einer Glasübergangstemperatur der leitfähigen Tinte und einer maximalen Temperatur der thermischen Stabilität der leitfähigen Tinte einschließt, wobei die Glasübergangstemperatur niedriger ist als die maximale Temperatur der thermischen Stabilität und die maximale Temperatur der thermischen Stabilität größer als 155 °C ist.

4. Verfahren nach einem der vorhergehenden Ansprüche, wobei der Schritt des Abscheidens einen Siebdruck der leitfähigen Tinte auf dem dielektrischen Film einschließt.

5. Verfahren nach einem der vorhergehenden Ansprüche, wobei der Schritt des Abscheidens das Abscheiden einer gemusterten Schicht der leitfähigen Tinte einschließt.

6. Verfahren nach einem der vorhergehenden Ansprüche, ferner einschließend das Aufbringen der leitenden Schaltung auf mindestens eine Plattenhaut einer Bodenplatte eines Flugzeugs.

7. Beheizte Bodenplatte (100; 200) eines Flugzeugs, umfassend:
mindestens eine Bodenplatte (102; 202) eines Flugzeugs schließt ein Heizelement (105; 205) mit einer leitenden Schaltung (101; 201) ein, die in der Bodenplatte positioniert ist, wobei der spezifische Widerstand des Heizelements kleiner als 1,68 x 10-6 Ohmmeter ist; wobei die leitende Schaltung eine gehärtete leitende Tinte (106; 206) einschließt; **dadurch gekennzeichnet, dass**
die Tinte eine Tinte aus Silberpartikeln in einem Epoxidharz ist, die auf einem dielektrischen Film (104; 204) abgeschieden wird, wobei eine 0,001 Zoll (50,8 Mikrometer) bis 0,004 Zoll (101,6 Mikrometer) dicke Nachhärtungsschicht der leitfähigen Tinte konfiguriert ist, um den spezifischen Widerstand des Heizelements zu erreichen und um eine Zylinderstange mit einem Durchmesser von 1/4 Zoll (0,635 cm) gebogen zu sein, ohne eine Verschlechterung des elektrischen Widerstands zu erfahren, und wobei die Silberbelastung zwischen 65 Gew.-%-95 Gew.-% trockener Tinte entspricht.

8. Beheizte Bodenplatte eines Flugzeugs nach Anspruch 7, wobei die gehärtete leitfähige Tinte auf dem dielektrischen Film in einer gemusterten Schicht angeordnet ist.

9. Beheizte Bodenplatte eines Flugzeugs nach Anspruch 7 oder 8, wobei die leitende Schaltung bei einer Temperatur zwischen einer Glasübergangstemperatur der leitfähigen Tinte und einer maximalen Temperatur der thermischen Stabilität der leitfähigen Tinte nachgehärtet wird, wobei die Glasübergangstemperatur niedriger ist als die maximale Temperatur der thermischen Stabilität und die maximale Temperatur der thermischen Stabilität größer als 155 °C ist.

## Revendications

1. Procédé de formation d'un élément de chauffage (105, 205) d'un panneau de plancher chauffé d'aéronef, le procédé comprenant :
le dépôt d'une encre conductrice (106 ; 206) de particules d'argent dans une résine époxy pour créer un circuit conducteur (101 ; 201); et
le durcissement à chaud du circuit conducteur pour obtenir une résistivité de l'élément de chauffage inférieure à 1,68 x 10-6 ohm-mètre ;
**caractérisé en ce que** l'encre conductrice est déposée sur un film diélectrique ; une couche de post-durcissement de 0,001 pouce (50,8 microns) à 0,004 pouce (101,6 microns) d'épaisseur de l'encre conductrice est configurée pour obtenir la résistivité de l'élément de chauffage et être pliée autour d'une tige cylindrique de 1/4 pouce (0,635 cm) de diamètre sans subir de dégradation de la résistance électrique ; et la charge d'argent est comprise entre 65 % et 95 % en poids/poids d'encre sèche.

2. Procédé selon la revendication 1 ou 2, dans lequel l'étape de durcissement à chaud comporte le durcissement à une température comprise entre 155 °C et 200 °C.

3. Procédé selon une quelconque revendication précédente, dans lequel l'étape de durcissement thermique comporte le durcissement à une température entre une température de transition vitreuse de l'encre conductrice et une température de stabilité thermique maximale de l'encre conductrice, dans lequel la température de transition vitreuse est inférieure à la température de stabilité thermique maximale et la température de stabilité thermique maximale est supérieure à 155 °C.

4. Procédé selon une quelconque revendication précédente, dans lequel l'étape de dépôt comporte la sérigraphie de l'encre conductrice sur le film diélectrique.

5. Procédé selon une quelconque revendication précédente, dans lequel l'étape de dépôt comporte le dépôt d'une couche à motif de l'encre conductrice.

6. Procédé selon une quelconque revendication précédente, comportant en outre l'application du circuit conducteur à au moins un revêtement de panneau d'un panneau de plancher d'aéronef.

7. Panneau de plancher chauffé d'aéronef (100 ; 200) comprenant :
au moins un panneau de plancher (102 ; 202) d'un aéronef comporte un élément de chauffage (105 ; 205) avec un circuit conducteur (101 ; 201) positionné à l'intérieur du panneau de plancher, où la résistivité de l'élément de chauffage est inférieure à 1,68 x 10-6 ohm-mètre ; dans lequel le circuit conducteur comporte une encre conductrice (106 ; 206) durcie ; **caractérisé en ce que**
l'encre est une encre de particules d'argent dans une résine époxy déposée sur un film diélectrique (104 ; 204), dans lequel une couche de post-durcissement de 0,001 pouce (50,8 microns) à 0,004 pouce (101,6 microns) d'épaisseur de l'encre conductrice est configurée pour obtenir la résistivité de l'élément de chauffage et être pliée autour d'une tige cylindrique de 1/4 pouce (0,635 cm) de diamètre sans subir de dégradation de la résistance électrique, et dans lequel la charge d'argent est comprise entre 65 % et 95 % en poids/poids d'encre sèche.

8. Panneau de plancher chauffé d'aéronef selon la revendication 7, dans lequel l'encre conductrice durcie est disposée sur le film diélectrique dans une couche à motif.

9. Panneau de plancher chauffé d'aéronef selon la revendication 7 ou 8, dans lequel le circuit conducteur est post-durci à une température entre une température de transition vitreuse de l'encre conductrice et une température de stabilité thermique maximale de l'encre conductrice, dans lequel la température de transition vitreuse est inférieure à la température de stabilité thermique maximale et la température de stabilité thermique maximale est supérieure à 155 °C.
